# EUROPEAN PATENT APPLICATION

(11) **EP 1 650 842 A2**
(43) Date of publication of application: **26.04.2006**
(21) Application number: 05021894.0
(22) Date of filing: 07.10.2005
(51) Int. Cl.: H01S 5/34

(54) **Broadband light source and method for fabricating the same**

(30) Priority: 20.10.2004 KR 2004083898
(71) Applicant: Samsung Electronics Co., Ltd., Yeongtong-gu Suwon-si, Gyeonggi-do (KR)
(72) Inventor: Heo, Du-Chang, Yeongtong-gu, Suwon-si, Gyeonggi-do (KR); Lee, Jeong-Seok, Yeongtong-gu, Suwon-si, Gyeonggi-do (KR); Hwang, Seong-Taek, Yeongtong-gu, Suwon-si, Gyeonggi-do (KR)
(74) Representative: Grünecker, Kinkeldey, Stockmair & Schwanhäusser Anwaltssozietät

(57) **Abstract**

Disclosed are a broadband light source and a method of fabricating the same. The method includes the steps of forming a lower clad on a substrate, forming an active layer having a multiple well structure on the lower clad (so as to generate light having a broad wavelength band), sequentially depositing an upper clad and a cap on the active layer, depositing a cover layer including at least two regions having bandgaps different from each other on the cap, and heat-treating the broadband light source including the cover layer.

## Description

### BACKGROUND OF THE INVENTION

### 1. Field of the Invention

The present invention relates to a broadband light source, and more particularly to a broadband light source having a quantum well structure.

### 2. Description of the Related Art

Optical fiber amplifiers or semiconductor amplifiers capable of generating incoherent spontaneous emission are used as broadband light sources. Such broadband light sources may be used as a light source for a Fabry-Perot laser, to generate external injection light for inducing a wavelength-lock or to generate light for creating multiple channels in a WDM (wavelength division multiplex) optical communication system.

In addition, a semiconductor light source having a multiple quantum well structure can be used as a broadband light source. In order to generate broadband wavelength light using such semiconductor light sources, quantum wells are formed having mutually different energy levels (or various light generated with different energy levels are combined with each other), thereby creating broadband wavelength light.

However, such a semiconductor light source cannot easily control the thickness of a quantum well. Further, it is difficult to control the wavelength characteristic of the quantum well after the quantum well has been grown. Since the optical gain may vary depending on the sort of the quantum well, it is difficult to constantly obtain light having a desired wavelength band through the semiconductor light source having the multiple quantum well structure.

### SUMMARY OF THE INVENTION

Accordingly, the present invention has been made to solve the above-mentioned problems occurring in the prior art and provides additional advantages, by providing a semiconductor light source having a multiple quantum well structure capable of stably generating light having a broad wavelength band by controlling a bandgap after the semiconductor light source has been grown on a substrate.

In accordance with the principles of the present invention, a method of fabricating a broadband light source is provided. The method comprises the steps of forming a lower clad on a substrate; forming an active layer having a multiple well structure on the lower clad; sequentially depositing an upper clad and a cap on the active layer; depositing a cover layer including at least two regions having bandgaps different from each other on the cap; and heat-treating the broadband light source including the cover layer.

### BRIEF DESCRIPTION OF THE DRAWINGS

The present invention will be more apparent from the following detailed description taken in conjunction with the accompanying drawings, in which:
FIG 1 is a view illustrating a broadband light source having a quantum well structure according to a first embodiment of the present invention;
FIG. 2 is a view illustrating an energy bandgap of first and second regions shown in FIG. 1;
FIG. 3 is a view illustrating wavelengths of light outputted from first and second regions shown in FIG. 1;
FIG. 4 is a plan view illustrating a broadband light source shown in FIG. 1 according to one embodiment of the present invention;
FIG. 5 is a plan view illustrating a broadband light source shown in FIG. 1 according to another embodiment of the present invention;
FIGS. 6 and 7 are graphs for explaining a relationship between areas of the first and second regions shown in FIG. 5 and a gain of light;
FIG. 8 is a plan view illustrating a broadband light source according to a second embodiment of the present invention; and
FIG. 9 is a plan view illustrating a broadband light source according to a third embodiment of the present invention.

### DETAILED DESCRIPTION

Hereinafter, embodiments of the present invention will be described with reference to the accompanying drawings. For the purposes of clarity and simplicity, a detailed description of known functions and configurations incorporated herein will be omitted as it may make the subject matter of the present invention unclear.

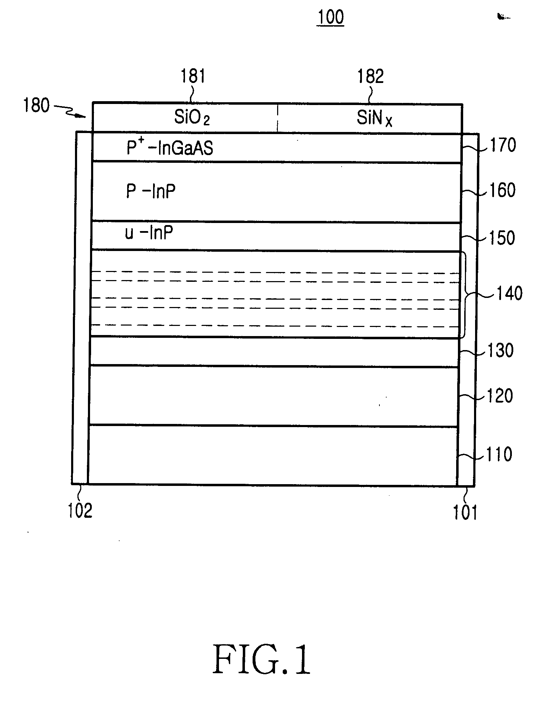

FIG 1 is a view illustrating a broadband light source having a quantum well structure according to a first embodiment of the present invention. As shown in FIG. 1, the broadband light source 100 according to the first embodiment of the present invention includes a substrate 110, a lower clad 120 formed on the substrate 110, an active layer 140 deposited on the lower clad 120 so as to generate light having a broad wavelength band, an upper clad 160 formed on the active layer 140, a cap layer 170 deposited on the upper clad layer 160, a cover layer 180 deposited on the cap layer 170 and formed with a plurality of regions made from different kinds of materials, and first and second protective layers 130 and 150. The first protective layer 130 is grown between the lower clad 120 and the active layer 140. The second protective layer 150 is grown between the upper clad 160 and the active layer 140.The cover layer 180 includes a first region 181 made from SiO₂ and a second region 182 made from SiNₓ.

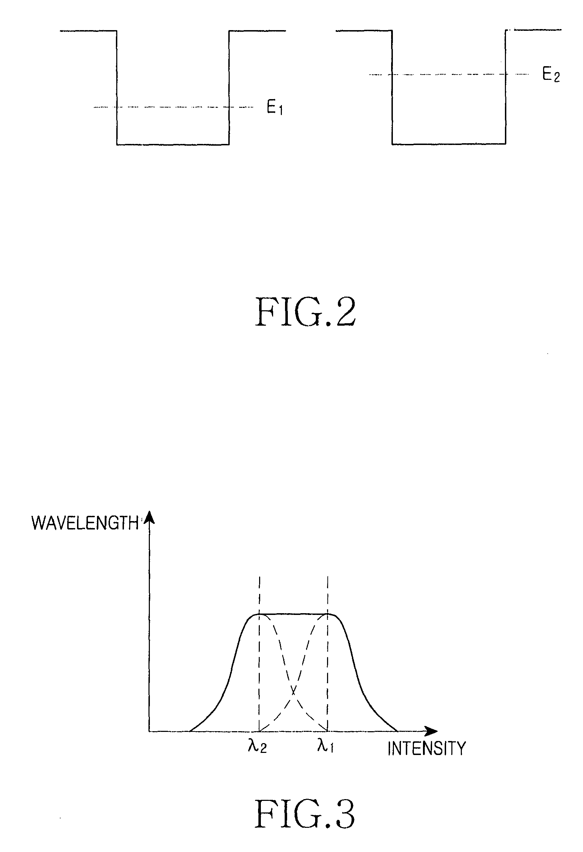

FIG. 2 is a view illustrating an energy bandgap of the first and second regions 181 and 182. As shown in FIG. 2, broadband light source is heat-treated at a temperature above 700°C in such a manner that the energy gap formed in the cover layer 180 can be locally controlled. That is, the quantum well structure shown in FIG 2 is changed into a smooth curve structure through a heat-treatment process.

FIG. 3 is a view illustrating wavelengths of light outputted from first and second regions shown in FIG. lAs shown in FIG 3, the broadband light source 100 may generate light having the broad wavelength band. When the broadband light source 100 formed with the cover layer 180 is heat-treated, the quantum well structure is changed, so the bandgap and the wavelength band of the light are also changed. That is, the bandgap of the cover layer 180 is changed after the heat-treatment process, so the wavelength thereof is also change. At this time, variation of the bandgap and the wavelength band of the first region 181 is different from that of the second region 182..

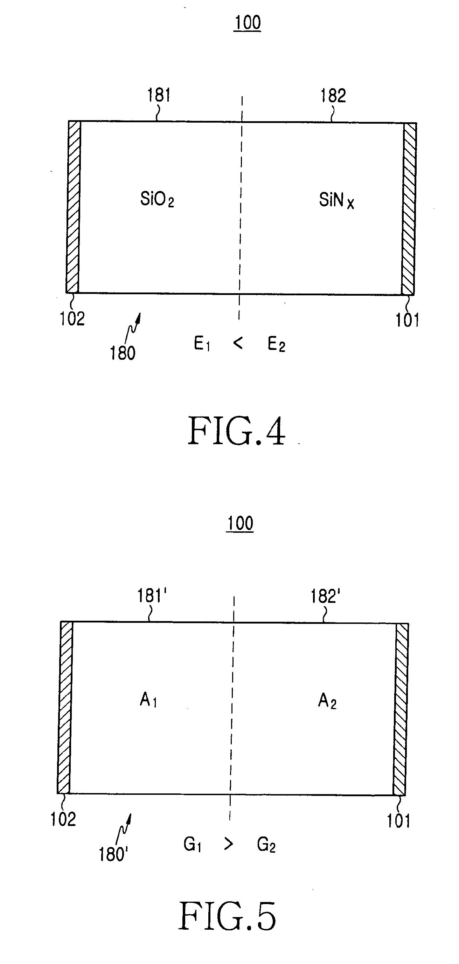

FIG. 4 is a plan view illustrating the broadband light source 100 shown in FIG. 1. When the energy bandgap of the second region 182 is higher than the energy bandgap of the first region 181, light generated from the broadband light source 100 including the second region 182 has a wavelength band shorter than a wavelength band of light generated from the broadband light source 100 including the first region 181. A high-reflective layer 102 is coated on one end of the broadband light source 100 including the first region 181, and a non-reflective layer 101 1 is coated on the other end of the broadband light source 100 including the first region 181.

The broadband light source 100 is subject to an impurity free vacancy disordering (IFVD) process at a temperature above 700°C after the cover layer 180 has been formed on the cap layer 170, so that the bandgap thereof is changed. In addition, such variation of the bandgap in the first region 181 is different from that of the second region 182. The broadband light source 100 according to the first embodiment of the present invention may locally control the bandgap of each region, thereby generating light having the broad wavelength band.

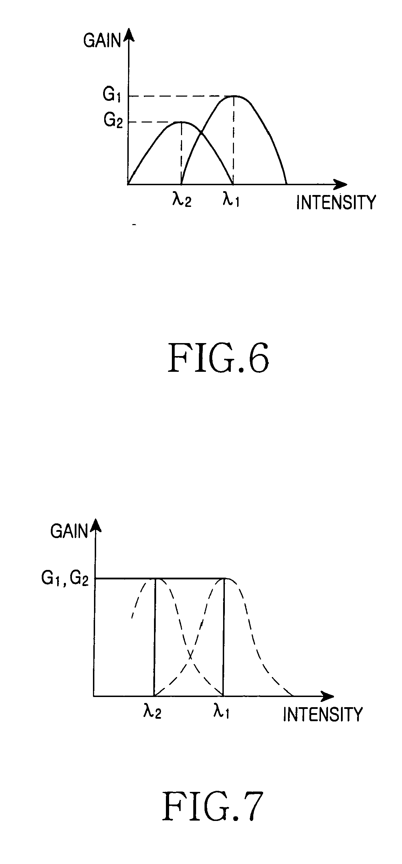

FIG. 5 is a plan view of a broadband light source 100 for illustrating the first and second regions of the cover layer shown in FIG. 1 according to another embodiment of the present invention. FIGS. 6 and 7 are graphs for explaining the relationship between widths G₁ and G₂ of first and second regions 181' and 182' shown in FIG 5 and a gain of light.

As shown in FIGs. 5 and 6, when the gain of the first region 181' is larger than the gain of the second region 182', areas A₁ and A₂ of the first and second regions 181' and 182' are adjusted in such a manner that intensity of light generated from the first and second regions 181' and 182' can be constantly adjusted. That is, the gain of each region forming the cover layer 180' is proportional to the area thereof, so the gains of lights having mutually different wavelengths can be constantly controlled by adjusting the areas of the regions. The broadband light source 100 includes a high-reflective layer 102 and a non-reflective layer 101.

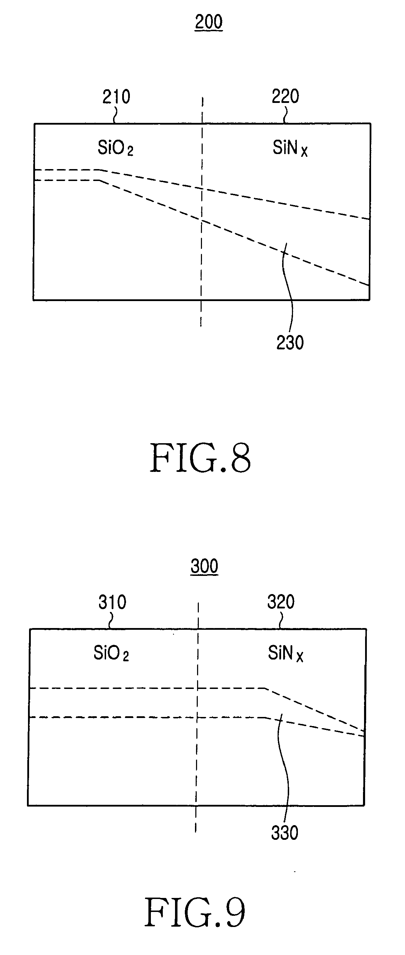

FIG. 8 is a plan view illustrating a multi-wavelength light source 200 including a cover layer formed with first and second regions 210 and 220 made from different kinds of materials according to a second embodiment of the present invention.

The multi-wavelength light source 200 shown in FIG. 8 includes a high-reflective layer coated on one surface of the multi-wavelength light source 200 having the first region 210 and a non-reflective layer coated on the other surface of the multi-wavelength light source 200 having the second region 220. Light is generated through the non-reflective layer. An active layer 230 is tapered from the second region 220 to the first region 210, so the gain of light may increase along a proceeding direction of the light.

FIG. 9 is a plan view illustrating a reflective type semiconductor optical amplifier 300 including a cover layer formed with first and second regions 310 and 320 made from different kinds of materials according to a third embodiment of the present invention.

The reflective type semiconductor optical amplifier 300 shown in FIG 9 includes a high-reflective layer coated on one surface of the reflective type semiconductor optical amplifier 300 having the first region 310 and a non-reflective layer coated on the other surface of the reflective type semiconductor optical amplifier 300 having the second region 320. The reflective type semiconductor optical amplifier 300 includes an spot size converter (SSC) having an active layer 330, which is tapered at the second region 320. That is, the reflective type semiconductor optical amplifier 300 having the above active layer 330 according to the third embodiment of the present invention improves an far-field pattern (FFP), so it can be coupled with optical fiber with a high coupling efficiency.

As described above, a broadband light source according to the present invention includes a cover layer having a plurality of regions made from different kinds of materials. The regions have bandgaps different from each other after the broadband light source has been subject to an IFVD process, such as a heat-treatment process. Thus, the broadband light source can stably generate light having the broad wavelength band. In addition, the broadband light source can be integrated on a single substrate, so productivity for the broadband light source may improve. Furthermore, the present invention can easily control the gain and he wavelength band of light by adjusting areas of the regions and the bandgaps thereof, so it is possible to produce articles having various specifications.

While the invention has been shown and described with reference to certain preferred embodiments thereof, it will be understood by those skillec in the art that various changes in form and details may be made therein without departing from the spirit and scope of the invention as defined by the appended claims.

## Claims

1. A method of fabricating a broadband light source (100,200,300), the method comprising the steps of:
forming a lower clad (120) on a substrate (110);
forming an active layer (140) having a multiple well structure on the lower clad (120);
sequentially depositing an upper clad (160) and a cap (170) on the active layer (140);
depositing a cover layer (180) including at least two regions (181,182,210,220,310,320) having bandgaps different from each other on the cap (170); and
heat-treating the broadband light source (100,200,300) including the cover layer (180).

2. The method as claimed in claim 1, wherein the cover layer (180) includes a first region (181,210,310) made from SiO₂ and a second region (182,220,320) made from SiNₓ, which are deposited on the cap in parallel to each other.

3. The method as claimed in claim 1 or 2, wherein the broadband light source (100,200,300) is heat-treated at a temperature above 700°C.

4. A broadband light source (100,200,300) comprising:
a substrate (110);
a lower clad (120) formed on the substrate (110);
an active layer (140) deposited on the lower clad (120);
an upper clad (160) formed on the active layer (140);
a cap layer (170) deposited on the upper clad (160); and
a cover layer (180) including a plurality of regions (181,182,210,220,310,320) made from different materials and deposited on the cap (170).

5. The broadband light source as claimed in claim 4, wherein the cover layer (180) includes a first region (181,210,310) made from SiO₂ and a second region (182,220,320) made from SiNₓ.

6. The broadband light source as claimed in claim 4 or 5, wherein the broadband light source (100,200,300) is heat-treated at a temperature above 700°C.

7. The broadband light source as claimed in any of claims 4 to 6, wherein the broadband light source (100,200,300) includes a high-reflective layer (102) coated on a first surface of the broadband light source (100,200,300) including the first region (181,210,310) and a non-reflective layer (101) coated on a second surface of the broadband light source (100,200,300) including the second region (182,220,320).

8. The broadband light source as claimed in any of claims 4 to 7, wherein a gain of light generated from each region (181,182,210,220,310,320) is proportional to an area of each region (181,182,210,220,310,320) and the size of the regions (181,182,210,220,310,320) is preferably equal or different.

9. A method of fabricating a broadband light source, the method comprising the steps of:
forming an active layer (140) having a multiple well structure on a substrate (110);
depositing a cover layer (180) including at least two regions (181,182,210,220,310,320) having bandgaps different from each other on the substrate; and
heat-treating the broadband light source including the cover layer.

10. The method as claimed in claim 9, further including the steps of forming a lower clad (120) on the substrate (110), sequentially depositing an upper clad (160) and a cap (170) on the active layer (140).

11. A broadband light source formed on a substrate, the broadband light source comprising:
an active layer (140) deposited on the substrate (110); and
a cover layer (180) including a plurality of regions (181,182,210,220,310,320) made from different materials and deposited on the substrate (110).

12. The broadband light source as claimed in claim 11, further including a lower clad (120) formed on the substrate (110); an upper clad (160) formed on the active layer (140); a cap (170) layer deposited on the upper clad (160).
